# EUROPÄISCHE PATENTSCHRIFT

(11) **EP 4 150 663 B1**
(45) Veröffentlichungstag und Bekanntmachung des Hinweises auf die Patenterteilung: **24.04.2024**
(21) Anmeldenummer: 21731892.2
(22) Anmeldetag: 07.05.2021
(51) Int. Cl.: H01L 21/67, H01L 21/673

(54) **HALTEVORRICHTUNG UND VERWENDUNG DER HALTEVORRICHTUNG**
HOLDING DEVICE, AND USE OF THE HOLDING DEVICE
DISPOSITIF DE SUPPORT ET UTILISATION DUDIT DISPOSITIF DE SUPPORT

(30) Priorität: 11.05.2020 DE 102020112641
(43) Veröffentlichungstag der Anmeldung: 22.03.2023
(73) Patentinhaber: Hanwha Q CELLS GmbH, 06766 Bitterfeld-Wolfen (DE)
(72) Erfinder: SCHAPER, Martin, 06766 Bitterfeld-Wolfen (DE)
(74) Vertreter: adares Patent- und Rechtsanwälte Reininger & Partner GmbB
(86) Internationale Anmeldenummer: PCT/DE2021/100418
(87) Internationale Veröffentlichungsnummer: WO 2021/228323

(56) Entgegenhaltungen:
- EP-A1- 3 301 204
- WO-A1-96/27897
- WO-A1-2017/005253
- CN-U- 202 323 023
- DE-A1-102015 004 430
- US-A- 5 618 351

## Beschreibung

Die Erfindung betrifft eine Haltevorrichtung und eine Verwendung der Haltevorrichtung. Insbesondere betrifft die Erfindung eine Haltevorrichtung zum Halten eines Substrats bei einer plasmaunterstützten Abscheidung einer Schicht aus der Gasphase auf dem Substrat und eine Verwendung einer solchen Haltevorrichtung.

Aus der DE102015004430A1 ist eine Haltevorrichtung zum Halten mehrerer Substrate bei einer plasmaunterstützten Abscheidung einer Schicht aus der Gasphase auf den Substraten bekannt. Die Haltevorrichtung weist parallel zueinander angeordnete Träger-Innenplatten auf, die ausgebildet sind, auf einander gegenüberliegenden Seiten jeweils Substrate zu tragen. Ferner weist sie parallel zu den Träger-Innenplatten angeordnete Träger-Außenplatten mit einer den Träger-Innenplatten zugewandten Innenseite und einer von den Träger-Innenplatten abgewandten Außenseite auf. Jede Träger-Außenplatte ist ausgebildet, auf ihrer Innenseite ein oder mehrere Substrate zu tragen und auf ihrer Außenseite Substrat-frei zu sein.

Die Träger-Innenplatten und Träger-Außenplatten weisen jeweils eine geeignete Halterung wie beispielsweise Substrattaschen, Haltestifte oder dgl. auf, um die Substrate zu halten, wobei einzelne Substrate in der Haltevorrichtung in einem vorbestimmten Abstand zueinander gehalten werden müssen, um ein möglichst gleichmäßiges Durchströmen von Gasen durch sämtliche Zwischenräume und die Ausbildung eines Plasmas zwischen den Substraten zu ermöglichen. Dadurch wird eine gleichmäßige Beschichtung der Substrate sichergestellt.

Die Haltevorrichtung, die im Fachjargon auch als Boot bezeichnet wird, dient dabei insbesondere dazu, möglichst viele Substrate wie Wafer für die Fertigung von Solarzellen sicher aufzunehmen, so dass eine Handhabung und Prozessierung einer mit Substraten bestückten Haltevorrichtung ohne Gefahr einer Beschädigung der Substrate möglich ist.

Um die Substrate bei einer chemischen Gasphasenabscheidung wie zum Beispiel einem PECVD-Prozess zu beschichten, werden sie zunächst auf den Trägerplatten der Haltevorrichtung angeordnet und dann wird die Haltevorrichtung in einer chemischen Abscheidevorrichtung wie beispielsweise einem beheizbaren Rohr einer PECVD Anlage angeordnet. In dem Abscheide- bzw. Beschichtungsprozess wird eine Schicht auf den Substraten abgeschieden, die sich in der Haltevorrichtung befinden. Vor der Beschichtung wird die sich in der chemischen Dampfabscheidevorrichtung befindende Haltevorrichtung aber zunächst auf eine vorbestimmte Prozesstemperatur erhitzt, die von der auf den Substraten zu erzeugenden Schicht abhängt. Das Erhitzen erfolgt durch eine von außen in Richtung der Haltevorrichtung einwirkenden Wärmestrahlung. Dabei heizen sich die Träger-Innenplatten und die Träger-Außenplatten jedoch unterschiedlich schnell auf. Die Temperaturunterschiede im Bereich verschiedener Trägerplatten führen jedoch zu ungleichmäßigen Ergebnissen bei der Schichtabscheidung, woraus unerwünschte Wirkungsgradverluste resultieren.

Insbesondere bei der Mehrschichtabscheidung wie beispielsweise bei einer Abscheidung von AlOx (Aluminiumoxid) und SiNx (Siliziumnitrid) auf die Substrate sind unterschiedliche Prozesstemperaturen erforderlich, was eine Änderung der Temperatur während des Prozesses erforderlich macht. Hierbei sind auftretende Temperaturunterschiede im Bereich unterschiedlicher Trägerplatten nachteilig.

EP 3 301 204 A1 beschreibt eine Heizvorrichtung, in der eine Haltevorrichtung zum Halten mehrerer Substrate bei einer plasmaunterstützten Abscheidung einer Schicht aus der Gasphase auf den Substraten angeordnet werden kann. Die Haltevorrichtung weist parallel zueinander angeordnete Trägerplatten auf. Die Heizvorrichtung weist eine Kammer und Heizmittel auf, die außerhalb der Kammer angeordnet sind. Um ein gleichmäßigeres Heizen in der Heizvorrichtung zu erreichen, sind die Heizmittel ausgebildet, entsprechend einem variierenden Profil eine Heizwirkung bereitzustellen, und weisen eine spezielle Struktur auf.

WO 96/27897 A1 beschreibt eine Vorrichtung, in die eine Halteeinrichtung mit Trägerplatten auf einem Sockel eingeführt werden kann. Die Halteeinrichtung weist koaxiale ringförmige Wärmeschilde auf, um eine übermäßige Erwärmung im Randbereich von Wafern zu verhindern, und Waferhaltevorsprünge auf, um die Wafer zu halten.

Es besteht aber weiterhin ein Bedarf eine Haltevorrichtung bereitzustellen, die eine gleichmäßigere Temperaturverteilung im Bereich der Träger-Innenplatten und Träger-Außenplatten realisiert.

Es ist daher eine Aufgabe der Erfindung, eine Haltevorrichtung bereitzustellen, die eine gleichmäßigere Temperaturverteilung im Bereich der Träger-Innenplatten und Träger-Außenplatten realisiert, um homogenere Ergebnisse bei der Dünnschichterzeugung in chemischen Dampfabscheideverfahren zu realisieren.

Erfindungsgemäß wird diese Aufgabe durch eine Haltvorrichtung mit den Merkmalen des Anspruchs 1 und eine Verwendung einer Haltevorrichtung mit den Merkmalen des Patentanspruchs 11 gelöst. Vorteilhafte Weiterbildungen und Modifikationen sind in den Unteransprüchen angegeben.

Erfindungsgemäß weist die Haltevorrichtung weiterhin Abschirmplatten auf, die jeweils beabstandet zur Außenseite der Träger-Außenplatte derart angeordnet sind, dass die Abschirmplatten die Träger-Außenplatten in einer Aufsicht auf die Träger-Außenplatten zumindest größtenteils abschatten, wobei jede Abschirmplatte ausgebildet ist, Substrat-frei zu sein.

Die Erfindung basiert auf dem Grundgedanken, dass bei der Haltevorrichtung gemäß Stand der Technik während des Abscheideprozesses von außen auf die Haltevorrichtung einfallende Wärmestrahlung direkt auf die Träger-Außenplatten der Haltevorrichtung trifft. Die zwischen den beiden Träger-Außenplatten befindlichen Träger-Innenplatten sind jedoch durch die Träger-Außenplatten abgeschattet. Dadurch erhitzen sich die Träger-Außenplatten deutlich schneller als die Träger-Innenplatten. Damit die Haltevorrichtung im Bereich all ihrer Träger-Außen- und Träger-Innenplatten die gleiche Temperatur aufweist muss eine gewisse Zeit gewartet werden. Gleiches gilt für die Abkühlung während eines Prozesses oder bei der Überleitung von einem zum nächsten Prozess. Stellt die Umgebung der Haltevorrichtung die Wärmesenke dar, dauert es im Vergleich länger, bis die Träger-Innenplatten abkühlen als die Träger-Außenplatten. Entweder wird ein gewisser Temperaturgradient über die räumliche Verteilung der Träger-Außen- und - Innenplatten in Kauf genommen oder man muss entsprechend lange warten, bis sich das gewünschte thermische Gleichgewicht eingestellt hat.

Wartet man nicht lange genug, so stellen sich regelmäßig temperaturabhängige Inhomogenitäten bei der Schichtabscheidung auf den Substraten ein. Aus diesen Gründen sind die Abschirmplatten in der Funktion eines Hitzeschilds angeordnet. Die Anordnung erfolgt derart, dass der direkte Einfall von Wärmestrahlung von Bauelementen der Abscheidevorrichtung, die die Halteeinrichtung umgeben, auf die Träger-Außenplatten größtenteils blockiert ist. Ebenso reduzieren die Abschirmplatten die Abkühlrate der Träger-Außenplatten. Dadurch wird der dynamische Temperaturverlauf der Träger-Außenplatten den Träger-Innenplatten angenähert, so dass alle Substrattragenden Trägerplatten einen im Idealfall gleichen oder zumindest hinreichend ähnlichen Temperaturverlauf aufweisen.

Unter der Formulierung "die Abschirmplatten die Träger-Außenplatten in einer Aufsicht auf die Träger-Außenplatten zumindest größtenteils abschatten" ist zu versehen, dass die Abschirmplatten > 50%, bevorzugt >70%, bevorzugter > 90 %, noch bevorzugter 100% der Fläche der Träger-Außenplatten in einer senkrechten Aufsicht auf die Träger-Außenplatten geometrisch abschatten.

Unter der Formulierung "Substrat-frei" ist zu versehen, dass eine solche Substrat-freie Platte strukturell derart ausgebildet ist, kein Substrat während des Abscheideprozesses zu tragen. Eine Platte, die ausgebildet ist, ein Substrat zu tragen, weist beispielsweise eine Halterung wie beispielsweise strukturelle Elemente wie Substrattaschen, Haltestifte oder dgl. auf, um die Substrate zu fixieren.

Die Haltevorrichtung ist insbesondere als Boot für eine chemische Dampfabscheidevorrichtung bevorzugt PECVD-Abscheidevorrichtung, bevorzugter eine Rohr PECVD-Anlage ausgebildet. Die Haltevorrichtung weist insbesondere zwei Träger-Außenplatten und jeweils eine zugeordnete, also insgesamt zwei Abschirmplatten auf.

In einer bevorzugten Ausführungsform sind die Abschirmplatten und die Träger-Außenplatten und die Träger-Innenplatten flächig ausgebildet und im Wesentlichen parallel zueinander angeordnet. Unter dem Ausdruck "flächig" ist eine ebene, bevorzugt plane, durchgehende Struktur zu verstehen. Die Struktur kann jedoch auch in der Ebene ausgebildete Öffnungen aufweisen.

Alternativ oder kumulativ sind die Abschirmplatten bevorzugt jeweils parallel beabstandet zur Außenseite der Träger-Außenplatte angeordnet. Die Träger-Innenplatten und die Träger-Außenplatten sind bevorzugt alle über eine oder mehrere Stangen miteinander verbunden, so dass sie in einem vorbestimmten Abstand zueinander beabstandet sind. Beispielsweise sind die Träger-Innenplatten und die Träger-Außenlatten mittels Abstandshalter beanstandet, die Abschnitte der Stange(n) umhüllen. Auch die Abschirmplatten können mit den Träger-Innen- und -Außenplatten über diese eine oder mehreren Stangen miteinander verbunden sein, so dass sie in einem weiteren vorbestimmten Abstand zu den Träger-Außenplatten beabstandet sind, wobei der vorbestimmte Abstand und der weitere vorbestimmte Abstand gleich oder verschieden sein können. Die Abschirmplatten können aber an die Haltevorrichtung auch durch andere Verbindungsmittel montiert sein.

In einer bevorzugten Ausführungsform ist oder sind Längen- und/oder Breiten-Abmessungen der Abschirmplatten kleiner als Längen- und/oder Breiten-Abmessungen der Träger-Außenplatten. Dadurch wird gewährleistet, dass die Haltevorrichtung den Platz in der chemischen Abscheidevorrichtung optimiert ausnutzt.

Die Träger-Innenplatten und die Träger-Außenplatten sind gegeneinander isoliert wechselweise mit Anschlüssen eines Wechselspannungsgenerators verbunden, zumindest wenn sie sich in der chemischen Abscheidevorrichtung befinden, damit ein Plasma während der Durchführung eines Abscheidevorgangs erzeugt wird. Bevorzugt sind die Abschirmplatten frei von einem elektrischen Kontakt und auch nicht bei Einsatz der Haltevorrichtung in der chemischen Abscheidevorrichtung mit einem Anschluss eines Wechselspannungsgenerators verbunden. Alternativ bevorzugt weisen die Abschirmplatten einen elektrischen Kontakt auf und sind mit dem Anschluss eines Wechselspannungsgenerators verbunden. Sie weisen bevorzugt eine selbe Polarität wie die unmittelbar benachbart angeordneten Träger-Außenplatten auf.

In einer weiterhin bevorzugten Ausführungsform weist jede Abschirmplatte eine Kühlvorrichtung auf. Dies ist eine einfache Möglichkeit die Temperaturkinetik der Abschirmplatte und somit indirekt auch der benachbart dazu angeordneten Träger-Außenplatte zu beeinflussen.

Bevorzugt ist die Kühlvorrichtung als eine rippenartige und/oder wellenförmige Oberflächenstruktur jeder Abschirmplatte ausgebildet. D.h., die Oberflächenstruktur weist Erhebungen ähnlich zu einer Rippe und/oder eine Welle auf, um die Oberfläche der Abschirmplatte zu vergrößern. Dies ist eine einfach realisierbare Kühlvorrichtung, durch die sich die Temperaturkinetik der Abschirmplatte beeinflussen lässt.

Die Abschirmplatten können einlagig oder mehrlagig ausgebildet sein. Bevorzugt sind die mehrlagig ausgebildet. Dadurch wird die Abschirmung weiterhin verbessert.

In einer bevorzugten Ausführungsform sind die Abschirmplatten aus einem Grundmaterial ausgebildet, das ausgewählt ist aus der Gruppe aus Graphit, carbonfaserverstärktem Kunststoff oder carbonfaserverstärktem Kohlenstoff. Weiterhin kommen Carbide, Quarz oder Keramik als Grundmaterial in Betracht.

Das Grundmaterial kann unbeschichtet sein. Das Grundmaterial kann aber auch mit einer Beschichtung versehen sein. Die Beschichtung ist bevorzugt derart gewählt, dass sie Infrarotstrahlung gut reflektiert, während das Grundmaterial dann bevorzugt gewählt ist, dass es, auch wenn es aufgeheizt ist, möglichst weniger Infrarotstrahlung ausstrahlt als die .

Bevorzugt sind Außenseiten der Abschirmplatten mit einer Beschichtung in Form einer Metallschicht versehen. Dadurch wird weiterhin eine gute Wärmereflektion der Außenoberflächen der Abschirmplatten realisiert. Bevorzugt ist die Metallschicht als nicht korrosionsanfällige Edelmetallschicht ausgebildet. Die Edelmetallschicht ist beispielsweise eine Gold- oder Platinschicht. Die Außenseiten der Abschirmplatten können teil- oder vollflächig mit der Schicht versehen sein. Bevorzugt sind sie vollflächig mit der Schicht versehen.

Die Träger-Innenplatten und die Träger-Außenplatten sind bevorzugt aus einem Material ausgebildet, das ausgewählt ist aus der Gruppe aus Graphit, carbonfaserverstärktem Kunststoff oder carbonfaserverstärktem Kohlenstoff. Das Material kann unbeschichtet oder beschichtet sein.

Bevorzugt weisen die Träger-Innenplatten und die Träger-Außenplatten Aussparungen auf, in die die Substrate aufnehmbar sind. Beispielsweise weisen die Träger-Innenplatten und die Träger-Außenplatten jeweils weisen eine oder mehrere Substrattaschen auf. Diese dienen als Halterung für die Substrate. Die Träger-Innenplatten und die Träger-Außenplatten können ferner jeweils Haltestifte aufweisen, um die Substrate zu halten.

Auch die Abschirmplatten können Aussparungen, Öffnungen oder Löcher aufweisen. Dabei muss aber sichergestellt werden, dass die Löcher oder Öffnungen so dimensioniert werden, dass das gewünschte Maß an thermischer Abschirmung erreicht wird.

In einer bevorzugten Ausführungsform sind die Abschirmplatten Aussparungs-, Öffnungs- und Loch-frei ausgebildet. D.h., sie weisen keine Vertiefung, Öffnung oder Löcher auf. Dadurch wird eine hohe Abschirmung sichergestellt.

Ferner betrifft die Erfindung eine Verwendung der Haltevorrichtung gemäß einer oder mehreren der vorstehend beschriebenen Ausführungsformen bei einer plasmaunterstützten Abscheidung aus der Gasphase als Haltevorrichtung für Substrate, insbesondere aus Halbleiterwafern prozessierte Solarzellen.

Die erfindungsgemäße Verwendung sieht vor, dass eine als Boot für Dampfabscheideanlagen ausgebildete Haltevorrichtung bei einer plasmaunterstützten Abscheidung aus der Gasphase als Haltevorrichtung für Substrate verwendet wird. Auf diese Weise können die Substrate besonders homogen und aufwandsgünstig beschichtet werden. Die Dauer von Beschichtungsprozessen, in denen ein zeitliches Temperaturprofil durchlaufen werden muss, verringert sich, weil die Temperaturkinetik im Vergleich von Träger-Außenplatten und Träger-Innenplatten mit Hilfe der Abschirmplatten sowohl beim Aufheizen als auch beim Abkühlen einander angenähert sind.

Die Haltevorrichtung findet daher insbesondere Verwendung bei allen chemischen Dampfabscheideprozessen, die eine begrenzte Zeit für eine Temperaturstabilisierung aufweisen. Bevorzugt findet die Haltevorrichtung Verwendung bei allen Abscheideprozessen, die eine Rohr PECVD Anlage einsetzen und besonders bevorzugt, bei Abscheideprozessen, bei denen mehrere Schichten sukzessive in der gleichen Abscheideanlage bei unterschiedlichen Prozesstemperaturen abgeschieden werden.

Die Substrate sind beispielsweise Wafer. Bei den Substraten handelt es sich bevorzugt um Siliziumsubstrate und bevorzugter um

Siliziumsolarzellensubstrate. Bei der plasmaunterstützten Abscheidung aus der Gasphase handelt es sich bevorzugt um ein CVD (Chemical Vapor Deposition)- oder PECVD (Plasma Enhanced Chemical Vapor Deposition)- Verfahren.

Bevorzugt wird die Haltevorrichtung bei einer Abscheidung verwendet, bei der aus der Gasphase Silizium, Siliziumnitrid oder Siliziumoxinitrid, Siliziumcarbid und/oder Aluminiumoxid auf den Substraten abgeschieden wird oder werden. Bei den abgeschiedenen Schichten kann es sich um elektrisch leitfähige Schichten handeln, bei denen die vorstehenden Schichten dotiert sind.

Weitere Eigenschaften und Vorteile der Erfindung werden im Zusammenhang mit der in der Figur gezeigten Ausführungsform deutlich und nachfolgend exemplarisch beschrieben. Es zeigt schematisch und nicht maßstabsgetreu:

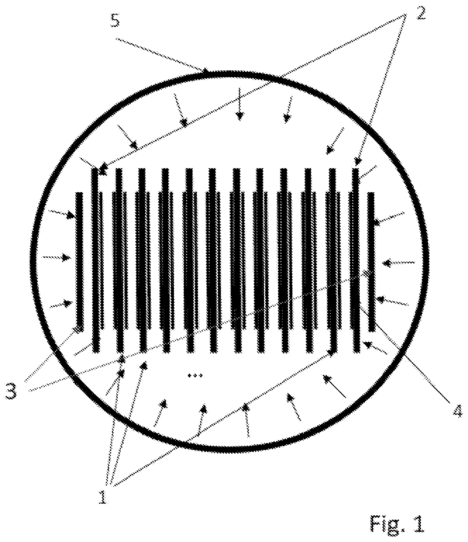

Fig. 1 eine Schnittansicht einer Prozesskammer einer chemischen Abscheidevorrichtung, in der eine erfindungsgemäße Haltevorrichtung angeordnet ist.

Fig. 1 zeigt eine Schnittansicht einer Prozesskammer einer chemischen Abscheidevorrichtung, in der eine erfindungsgemäße Haltevorrichtung angeordnet ist. Die erfindungsgemäße Haltevorrichtung ist in einer Prozesskammer 5 einer Rohr-PECVD-Abscheidevorrichtung angeordnet.

Die Haltevorrichtung weist eine Mehrzahl parallel zueinander angeordnete Träger-Innenplatten 1 auf. Jede Träger-Innenplatte 1 ist ausgebildet, auf einander gegenüberliegenden Seiten jeweils ein oder mehrere Substrate 4 zu tragen. Ferner weist die Haltevorrichtung zwei parallel zu den Träger-Innenplatten 1 angeordnete Träger-Außenplatten 2 mit jeweils einer den Träger-Innenplatten 1 zugewandten Innenseite und einer von den Träger-Innenplatten 1 abgewandten Außenseite auf. Jede Träger-Außenplatte 2 ist ausgebildet, auf ihrer Innenseite ein oder mehrere Substrate 4 zu tragen und auf ihrer Außenseite Substrat-frei zu sein, so dass sie auf ihrer Außenseite während der Abscheidung von Schichten kein Substrat aufweist. Die Träger-Innenplatten 1 und die Träger-Außenplatten 2 sind mittels einer oder mehrerer Stangen (nicht gezeigt) miteinander verbunden und durch Abstandshaltern (ebenfalls nicht gezeigt) voneinander in einem vorbestimmten Abstand beabstandet.

Weiterhin weist die Haltevorrichtung zwei Abschirmplatten 3 auf, die jeweils beabstandet zur Außenseite der Träger-Außenplatte 2 derart angeordnet sind, dass die Abschirmplatten 3 die Träger-Außenplatten 2 in einer Aufsicht auf die Träger-Außenplatten 2 zumindest größtenteils abschatten. Jede Abschirmplatte 3 ist ausgebildet, Substrat-frei zu sein, d.h., sie weisen keine Strukturen auf, die das Fixieren eines Substrates oder mehrerer Substrate erlauben.

Die Haltevorrichtung ist in der Prozesskammer 5 angeordnet, um auf den Substraten 4 eine oder mehrere Schichten mittels Chemischer Gasphasenreaktion abzuscheiden. Dazu wird die Prozesskammer 5 über eine nicht dargestellte Heizeinrichtung aufgewärmt, wodurch die Haltevorrichtung samt Substrat 4 und die Wand der rohrartigen Prozesskammer 5 ebenfalls aufheizen. Die Wand der Prozesskammer 5 strahlt Wärme ab, was durch die von der Wand der Prozesskammer ausgehenden kurzen Pfeile angedeutet ist. Die Abschirmplatten 3 schirmen die Träger-Außenplatten 2 größtenteils vor der Wärmestrahlung ab, die von der Wand der Prozesskammer 5 aus in Richtung der Träger-Außenplatten 2 emittiert wird. Dadurch wirkt ein Teil der Wärmestrahlung der Wand der Prozesskammer 5 zunächst vorwiegend auf die Abschirmplatten 3 und erst anschließend auf die Träger-Außenplatten 2 ein, wobei der übrige Teil der Wärmestrahlung ausgehend von der Wand der Prozesskammer auf die Träger-Innenplatten 1 und die Träger-Außenplatten 2 einfällt. Bei einer auf den spezifischen Abscheideprozess hin optimierten Temperatur-Kinetik der Abschirmplatte, lässt sich ein im Vergleich der Träger-Außenplatten und der Träger-Innenplatten im Wesentlichen ähnlicher Temperaturgang realisieren.

### Bezugszeichenliste:

- 1: Träger-Innenplatten
- 2: Träger-Außenplatten
- 3: Abschirmplatten
- 4: Substrat
- 5: Prozesskammer

## Patentansprüche

1. Haltevorrichtung zum Halten mehrerer Substrate (4) bei einer plasmaunterstützten Abscheidung einer Schicht aus der Gasphase auf den Substraten (4) aufweisend:
- parallel zueinander angeordnete Träger-Innenplatten (1), die ausgebildet sind, auf einander gegenüberliegenden Seiten jeweils Substrate (4) zu tragen,
- parallel zu den Träger-Innenplatten (1) angeordnete Träger-Außenplatten (2) mit einer den Träger-Innenplatten (1) zugewandten Innenseite und einer von den Träger-Innenplatten (1) abgewandten Außenseite, wobei jede Träger-Außenplatte (2) ausgebildet ist, auf ihrer Innenseite ein oder mehrere Substrate (4) zu tragen und auf ihrer Außenseite Substrat-frei zu sein, und weiter **gekennzeichnet durch**
- Abschirmplatten (3), die jeweils beabstandet zur Außenseite der Träger-Außenplatte (2) derart angeordnet sind, dass die Abschirmplatten (3) die Träger-Außenplatten (2) in einer Aufsicht auf die Träger-Außenplatten (2) zumindest größtenteils abschatten, wobei jede Abschirmplatte (3) ausgebildet ist, Substrat-frei zu sein.

2. Haltevorrichtung nach Anspruch 1, **dadurch gekennzeichnet, dass** die Abschirmplatten (3) und die Träger-Außenplatten (2) und die Träger-Innenplatten (1) flächig ausgebildet sind und im Wesentlichen parallel zueinander angeordnet sind und/oder dass die Abschirmplatten (3) jeweils parallel beabstandet zur Außenseite der Träger-Außenplatte (2) angeordnet sind.

3. Haltevorrichtung nach einem der vorangehenden Ansprüche, **dadurch gekennzeichnet, dass** Längen- und/oder Breiten-Abmessungen der Abschirmplatten (3) kleiner ist oder sind als Längen- und/oder Breiten-Abmessungen der Träger-Außenplatten (2).

4. Haltevorrichtung nach einem der vorangehenden Ansprüche, **dadurch gekennzeichnet, dass** die Abschirmplatten (3) frei von einem elektrischen Kontakt sind oder eine selbe Polarität wie die zu den Abschirmplatten (3) unmittelbar benachbarten Träger-Außenplatten (2) aufweisen.

5. Haltevorrichtung nach einem der vorangehenden Ansprüche, **dadurch gekennzeichnet, dass** jede Abschirmplatte (3) eine Kühlvorrichtung aufweist.

6. Haltevorrichtung nach Anspruch 5, **dadurch gekennzeichnet, dass** die Kühlvorrichtung als eine rippenartige und/oder wellenförmige Oberflächenstruktur jeder Abschirmplatte (3) ausgebildet ist.

7. Haltevorrichtung nach einem der vorangehenden Ansprüche, **dadurch gekennzeichnet, dass** die Abschirmplatten (3) mehrlagig ausgebildet sind.

8. Haltevorrichtung nach einem der vorangehenden Ansprüche, **dadurch gekennzeichnet, dass** die Abschirmplatten (3) aus einem Grundmaterial ausgebildet sind, das ausgewählt ist aus der Gruppe aus Graphit, carbonfaserverstärktem Kunststoff oder carbonfaserverstärktem Kohlenstoff.

9. Haltevorrichtung nach Anspruch 8, **dadurch gekennzeichnet, dass** Außenseiten der Abschirmplatten (3) mit einer Beschichtung in Form einer Metallschicht, insbesondere einer Edelmetallschicht versehen sind.

10. Haltevorrichtung nach einem der vorangehenden Ansprüche, **dadurch gekennzeichnet, dass** die Träger-Innenplatten (1) und die Träger-Außenplatten (2) Aussparungen aufweisen, in die die Substrate (4) aufnehmbar sind und/oder dass die Abschirmplatten (3) Aussparungs-, Öffnungs- und Loch-frei ausgebildet sind.

11. Verwendung der Haltevorrichtung nach einem der vorangehenden Ansprüche bei einer plasmaunterstützten Abscheidung aus der Gasphase als Haltevorrichtung für Substrate (4).

## Claims

1. A holding apparatus for holding a plurality of substrates (4) in a plasma-assisted deposition of a layer from the gas phase onto the substrate (4) comprising:
- carrier inner plates (1) arranged parallel to one another which are each configured for carrying substrates (4) on opposite sides,
- carrier outer plates (2) arranged parallel to the carrier inner plates (1) having an inner surface facing the carrier inner plates (1) and an outer surface facing away from the carrier inner plates (1), wherein each carrier outer plate (2) is configured for carrying one or more substrates (4) on its inner surface and to be substrate-free on its outer surface and
- shielding plates (3) which are arranged in each case spaced apart from the outside of the carrier outer plate (2) such that the shielding plates (3) at least very largely shade the carrier outer plates (2) in a plan view of the carrier outer plates (2), wherein each shielding plate (3) is configured to be substrate-free.

2. The holding apparatus as claimed in claim 1, **characterized in that** the shielding plates (3) and the carrier outer plates (2) and the carrier inner plates (1) are flat and arranged substantially parallel to one another and/or **in that** the shielding plates (3) are arranged in each case in parallel spaced apart from the outer surface of the carrier outer plate (2).

3. The holding apparatus as claimed in either of the preceding claims, **characterized in that** length and/or width measurements of the shielding plates (3) is or are smaller than length and/or width measurements of the carrier outer plates (2).

4. The holding apparatus as claimed in any of the preceding claims, **characterized in that** the shielding plates (3) are free from an electrical contact or have the same polarity as the carrier outer plates (2) immediately adjacent to the shielding plates (3).

5. The holding apparatus as claimed in any of the preceding claims, **characterized in that** each shielding plate (3) comprises a cooling means.

6. The holding apparatus as claimed in claim 5, **characterized in that** the cooling means is in the form of a rib-like and/or wave-shaped surface structure of each shielding plate (3).

7. The holding apparatus as claimed in any of the preceding claims, **characterized in that** the shielding plates (3) are multilayered.

8. The holding apparatus as claimed in any of the preceding claims, **characterized in that** the shielding plates (3) are made of a base material selected from the group of graphite, carbon fiber-reinforced plastic or carbon fiber-reinforced carbon.

9. The holding apparatus as claimed in claim 8, **characterized in that** outer surfaces of the shielding plates (3) are preferably provided with a coating in the form of a metal layer, in particular a noble metal layer.

10. The holding apparatus as claimed in any of the preceding claims, **characterized in that** the carrier inner plates (1) and the carrier outer plates (2) comprise cutouts in which the substrates (4) may be accommodated and/or in that the shielding plates (3) are free from cutouts, openings and holes.

11. The use of the holding apparatus as claimed in any of the preceding claims in a plasma-assisted deposition from the gas phase as a holding apparatus for substrates (4).

## Revendications

1. Un dispositif de maintien de plusieurs substrats (4) lors d'un dépôt assisté par plasma d'une couche de la phase gazeuse sur les substrats (4), comprenant :
- des plaques intérieures de support (1) disposées en parallèle les unes aux autres, qui sont conçues pour supporter des substrats (4) sur des côtés opposés,
- des plaques extérieures de support (2) disposées parallèles aux plaques intérieures de support (1), qui ont un côté intérieur faisant face aux plaques intérieures de support (1) et un côté extérieur opposé aux plaques intérieures de support (1), chaque plaque extérieure de support (2) étant conçue pour supporter un ou plusieurs substrats (4) sur son côté intérieur et pour être exempte de substrat au côté extérieur, **caractérisé en outre par**
- des plaques de blindage (3), qui sont espacées du côté extérieur de la plaque de support extérieure (2) de telle sorte que les plaques de blindage (3) ombragent les plaques extérieures de support (2) au moins en grande partie en une vue de dessus sur les plaques extérieures de support (2), chaque plaque de blindage (3) étant conçue pour être exempte de substrat.

2. Le dispositif de maintien selon la revendication 1, **caractérisé en ce que** les plaques de blindage (3) et les plaques extérieures de support (2) et les plaques intérieures de support (1) sont en forme plane et sont disposées essentiellement parallèles les unes aux autres et/ou que les plaques de blindage (3) sont chacune disposées en parallèle et espacée au côté extérieur de la plaque de support extérieure (2).

3. Le dispositif de maintien selon l'une des revendications précédentes, **caractérisé en ce que** les dimensions de longueur et/ou de largeur des plaques de blindage (3) est ou sont inférieures aux dimensions de longueur et/ou de largeur des plaques extérieures de support (2).

4. Le dispositif de maintien selon l'une des revendications précédentes, **caractérisé en ce que** les plaques de blindage (3) sont exemptes de contact électrique ou ont la même polarité que les plaques extérieures de support (2) immédiatement adjacentes aux plaques de blindage (3).

5. Le dispositif de maintien selon l'une des revendications précédentes, **caractérisé en ce que** chaque plaque de blindage (3) a un dispositif de refroidissement.

6. Le dispositif de maintien selon la revendication 5, **caractérisé en ce que** le dispositif de refroidissement est formé d'une structure de surface en forme de nervure et/ou d'ondulation de chaque plaque de blindage (3).

7. Le dispositif de maintien selon l'une des revendications précédentes, **caractérisé en ce que** les plaques de blindage (3) sont multicouches.

8. Le dispositif de maintien selon l'une des revendications précédentes, **caractérisé en ce que** les plaques de blindage (3) sont formées d'un matériau de base choisi dans le groupe du graphite, du plastique renforcé de fibres de carbone ou du carbone renforcé de fibres de carbone.

9. Le dispositif de maintien selon la revendication 8, **caractérisé en ce que** les côtés extérieurs des plaques de blindage (3) sont pourvues d'un revêtement sous la forme d'une couche métallique, en particulier d'une couche de métal noble.

10. Le dispositif de maintien selon l'une des revendications précédentes, **caractérisé en ce que** les plaques intérieures de support (1) et les plaques extérieures de support (2) ont des évidements dans lesquels les substrats (4) peuvent être reçues et/ou que les plaques de blindage (3) sont conçues pour être exemptes d'évidements, d'ouvertures et de trous.

11. Une utilisation du dispositif de maintien selon l'une des revendications précédentes lors d'un dépôt assisté par plasma à partir de la phase gazeuse comme dispositif de maintien des substrats (4).
